# FASCICULE DE BREVET EUROPEEN

(11) **EP 3 238 308 B1**
(45) Date de publication et mention de la délivrance du brevet: **25.10.2023**
(21) Numéro de dépôt: 15823673.7
(22) Date de dépôt: 18.12.2015
(51) Int. Cl.: H02H 3/087, H02H 3/02, H02H 9/02, H03K 17/081

(54) **DISPOSITIF DE CONTRÔLE POUR LIGNE D'ALIMENTATION ÉLECTRIQUE**
STEUERUNGSVORRICHTUNG FÜR STROMLEITUNG
CONTROL DEVICE FOR POWER SUPPLY LINE

(30) Priorité: 23.12.2014 FR 1463206
(43) Date de publication de la demande: 01.11.2017
(73) Titulaire: Safran Electrical & Power, 31702 Blagnac Cedex (FR)
(72) Inventeur: BALPE, Cédric, 91800 Brunoy (FR); LHOMMEAU, Tony, 77127 Lieusaint (FR)
(74) Mandataire: Cabinet Beau de Loménie
(86) Numéro de dépôt international: PCT/FR2015/053623
(87) Numéro de publication internationale: WO 2016/102840

(56) Documents cités:
- WO-A1-2013/127463
- WO-A2-2008/057222
- WO-A2-2012/148774
- US-A1- 2003 218 845
- US-A1- 2010 277 847

## Description

### Arrière-plan de l'invention

L'invention se rapporte au domaine général de l'alimentation électrique, et plus particulièrement aux dispositifs de contrôle montés sur des lignes d'alimentation électrique.

On utilise traditionnellement des dispositifs placés sur les lignes d'alimentation pour contrôler le courant qui circulent dans ces lignes. Ces dispositifs permettent également d'obtenir une protection contre certains évènements tels que les courts-circuits ou l'apparition de foudre.

Ces dispositifs peuvent être contrôlés électroniquement et ils sont généralement désignés par l'homme du métier sous l'acronyme anglo-saxon SSPC (« Solid State Power Controller » : contrôleur de puissance à semi-conducteur). Leur fonctionnement est analogue à celui d'un disjoncteur électronique.

On peut noter que dans ces dispositifs, un courant est mesuré, et c'est en fonction de la valeur de ce courant qu'une décision est prise pour contrôler un composant semi-conducteur tel qu'un IGBT (« Insulated Gate Bipolar Transistor » en langue anglaise) ou un transistor MOSFET dans un état passant ou fermé.

Certaines applications impliquent l'utilisation sur les lignes d'alimentation électrique de courant continu haute tension (« HVDC : High Voltage Direct Current » en langue anglaise). Cela étant, les dispositifs actuels ne sont pas satisfaisants en ce qui concerne leur niveau de pertes, leur niveau d'intégration, et le niveau de protection qu'ils proposent.

De l'état de la technique antérieure, on connaît les documents WO 2013/127463, US 2010/277847, et EP 0 726 527. L'invention vise notamment à pallier ces inconvénients.

### Objet et résumé de l'invention

La présente invention, qui est définie par le jeu de revendications joint, répond à ce besoin en proposant un dispositif de contrôle, décrit dans la revendication 1, être placé entre deux portions d'une ligne d'alimentation électrique.

Selon une caractéristique générale, le dispositif comporte un transistor bipolaire comportant un matériau semi-conducteur à large bande et ayant son émetteur connecté à une portion de la ligne d'alimentation, son collecteur connecté à une autre portion de la ligne d'alimentation, le dispositif comportant en outre des moyens de commande connectés à la base dudit transistor et configurés pour fonctionner en boucle ouverte et sans contreréaction.

Les inventeurs ont observé que l'utilisation d'un transistor bipolaire comportant un matériau semi-conducteur à large bande (« Wide bandgap semiconductor » en anglais) permet d'obtenir une limitation précise du courant qui traverse ce transistor. De ce fait, on obtient une limitation réglable, qui est bien adaptée lors de l'apparition de courts circuits et de foudre. Cette limitation est intrinsèque à la structure du transistor comprenant un matériau semi-conducteur à large bande.

Ceci est bien différent des solutions selon l'art antérieur qui fonctionnent de manière analogue à un disjoncteur et qui ne permettent pas de limiter le courant qui circule dans la ligne d'alimentation électrique.

On peut noter qu'obtenir une limitation permet d'obtenir une protection supplémentaire par rapport aux dispositifs de l'art antérieur qui fonctionnent généralement entre deux états passant et bloqués. Ici, une élévation anormale du courant peut être traitée grâce à la limitation intrinsèque qui apparaît dans le transistor.

Cela est particulièrement avantageux pour les applications visant les aéronefs, au sein desquels il n'est pas toujours envisageable de stopper complétement la circulation de courant lors de l'apparition d'un événement tel que la foudre.

On peut également noter que lorsqu'un court-circuit apparaît dans la charge qui est alimentée par la ligne d'alimentation, la température augmente. Les transistors comprenant un matériau semi-conducteur à large présentent alors une limitation du courant qui les traverse qui est renforcée lorsque la température augmente. En d'autres termes, le courant traversant ces transistors diminue lorsque la température augmente, ce qui correspond à une protection supplémentaire due à l'utilisation de matériau semi-conducteur à large bande.

Aussi, contrairement aux dispositifs selon l'art antérieur qui utilisent des composants en silicium, ici, en utilisant un matériau semi-conducteur à large bande, on limite les pertes.

Par « comportant un matériau semi-conducteur à large bande », on entend un transistor dans lequel au moins une région de la base du transistor comporte un matériau semi-conducteur à large bande, au moins une région de l'émetteur comporte un matériau semi-conducteur à large bande, et au moins une région du collecteur comporte un matériau semi-conducteur à large bande. Un tel transistor peut être réalisé par exemple au sein d'une galette (« wafer » en langue anglaise) de ce matériau semi-conducteur à large bande.

Contrairement aux solutions selon l'art antérieur qui nécessitent l'utilisation d'une sonde sur la ligne d'alimentation pour mesurer le courant qui y circule et laisser ou non passer ce courant, ici, on peut directement contrôler le transistor pour qu'il fournisse un courant souhaité, et ce sans mesure du courant qui circule sur la ligne. C'est l'utilisation d'un transistor bipolaire comportant un matériau semi-conducteur à large bande qui permet cela, puisque ces transistors limitent précisément les courants qui les traversent.

Selon un mode particulier de réalisation, lesdits moyens de commande sont configurés pour délivrer un courant à la base dudit transistor, la valeur du courant étant choisie pour limiter une valeur maximale du courant traversant les portions de la ligne d'alimentation.

Selon un mode particulier de réalisation, lesdits moyens de commande comportent un interrupteur configuré pour connecter la base dudit transistor à une entrée du dispositif destinée à recevoir un premier courant de commande du transistor, ou à au moins une autre entrée du dispositif destinée à recevoir un deuxième courant de commande du transistor. Ainsi, plusieurs niveaux de courants de commande peuvent être utilisés en fonction de l'application souhaitée, par exemple en fonction du niveau de limitation souhaité.

Selon un mode particulier de réalisation, les moyens de commande comportent un générateur ajustable de tension et une résistance.

Selon un mode particulier de réalisation, le dispositif comporte en outre au moins une diode disposée en série avec la résistance et le générateur ajustable de tension.

Les diodes sont des composants électroniques influencés par la température, ceci permet d'ajuster le courant circulant vers la base du transistor, et donc de prendre en compte la température en amont de la commande du transistor, pour que la limitation de courant soit effectivement celle attendue alors que les conditions de température varient.

Selon un mode particulier de réalisation, la ligne d'alimentation électrique est destinée à recevoir un courant continu haute tension.

Selon un mode particulier de réalisation, le matériau semi-conducteur à large bande est choisi dans le groupe formé par : le carbure de silicium (SiC), le nitrure de gallium (GaN), et l'arséniure de gallium (AsGa).

L'invention propose également un système comprenant une source d'alimentation, une source d'alimentation, une charge, au moins une ligne d'alimentation reliant ladite source d'alimentation à ladite charge, et au moins un dispositif tel que défini ci-avant placé entre deux portions de ladite au moins une ligne d'alimentation.

### Brève description des dessins

D'autres caractéristiques et avantages de la présente invention ressortiront de la description faite ci-dessous, en référence aux dessins annexés qui en illustrent un exemple dépourvu de tout caractère limitatif.

Sur les figures :
- la figure 1 représente de manière schématique un système selon un mode de réalisation de l'invention,
- la figure 2 représente de façon schématique un dispositif selon un mode de réalisation de l'invention,
- la figure 3 représente de façon schématique un dispositif selon un autre mode de réalisation non couvert par la portée des revendications,
- les figures 4 et 5 sont des caractéristiques courant-tension d'un transistor d'un dispositif selon un mode de réalisation de l'invention, et
- la figure 6 représente l'évolution du courant dans une ligne d'alimentation en fonction du temps.

### Description détaillée d'un mode de réalisation

On va maintenant décrire des exemples de modes de réalisation dans lesquels le matériau semi-conducteur à large bande est du carbure de silicium. D'autres matériaux peuvent néanmoins être utilisés, notamment du nitrure de gallium ou de l'arséniure de gallium.

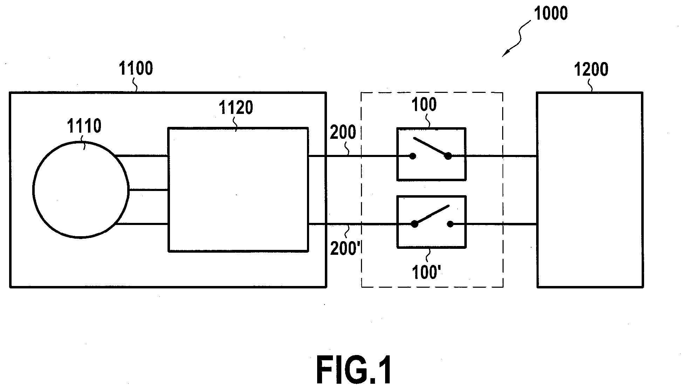

La figure 1 est un schéma représentant des dispositifs de contrôle 100 et 100' utilisés dans un système 1000 à courant continu haute tension (HVDC). Plus précisément, le dispositif de contrôle 100 est monté sur une ligne d'alimentation 200 présentant un potentiel positif, et le dispositif 100' est monté sur une ligne 200' de neutre.

Les lignes 200 et 200' débouchent d'une source d'alimentation 1100 produisant un courant continu haute tension. Cette source d'alimentation 1100 comporte un générateur de courant alternatif 1110 triphasé, et un convertisseur courant alternatif/courant continu 1120.

Enfin, les lignes d'alimentation 200 et 200' sont destinées à l'alimentation d'une charge 1200 destinée à être alimentée par un courant continu haute tension.

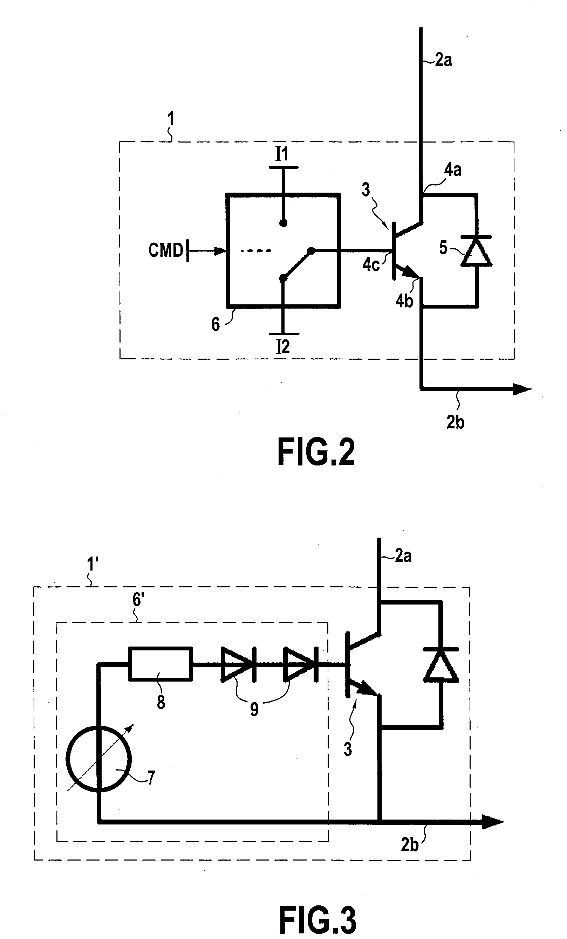

Sur la figure 2, on a représenté un dispositif de contrôle 1 selon l'invention, placé entre deux portions 2a et 2b d'une même ligne d'alimentation, par exemple une ligne d'alimentation électrique destinée à recevoir un courant continu haute tension.

La portion 2a de la ligne d'alimentation peut être connectée à une source d'alimentation en tension, et la portion 2b de la ligne d'alimentation peut être connectée à une charge à alimenter.

Le dispositif 1 est destiné à limiter le courant qui peut circuler dans la ligne d'alimentation. De ce fait, le dispositif 1 permet également d'obtenir une protection contre les courts-circuits apparaissant dans une charge reliée à la ligne d'alimentation, ou encore contre la foudre.

Le dispositif 1 comporte un transistor bipolaire comportant du carbure de silicium 3. Un tel transistor peut être réalisé par exemple au sein d'une galette (« wafer » en langue anglaise) de carbure de silicium, et son émetteur, son collecteur, et sa base comportent du carbure de silicium.

A titre indicatif, on pourra utiliser le transistor bipolaire comportant du carbure de silicium commercialisé sous la référence FSICBH017A120 par la société américaine Fairchild Semiconductor.

Le collecteur 4a du transistor 3 est connecté à la portion 2a de la ligne d'alimentation, et l'émetteur 4b du transistor 3 est connecté à l'autre portion 2b de la ligne d'alimentation. Le transistor 3 présente également une diode antiparallèle 5. C'est dans cette disposition que le transistor va limiter le courant qui le traverse qui est le courant qui traverse la ligne d'alimentation.

Pour commander le transistor 3, la base 4c de ce transistor est reliée à des moyens de commande 6. Ces moyens de commande 6 fournissent un courant à la base 4c du transistor 3, qui est directement liée à la valeur du courant que l'on souhaite voir traverser le transistor 3.

Dans l'exemple de la figure 1, les moyens de commande 6 comprennent un interrupteur, capable de connecter la base 4c du transistor 3 à un courant I1 correspondant à un état passant du transistor 3, ou à un courant I2 correspondant à un état bloqué du transistor 3. Le courant I1 est choisi en fonction du courant maximal que l'on souhaite laisser passer dans le transistor 3.

L'interrupteur des moyens de commande 6 reçoit un signal de commande CMD qui connecte la base 4c du transistor 3 à l'une ou l'autre des entrées recevant un courant I1 ou I2.

On peut noter que les moyens de commande 6 fonctionnent en boucle ouverte, et sans contreréaction : il n'est pas nécessaire de mesurer le courant circulant dans la ligne d'alimentation pour ajuster ce courant, puisque le transistor fournit une limitation précise du courant. Aucun capteur n'est par ailleurs prévu. La limitation est donc intrinsèque au transistor bipolaire, et il suffit de la régler par la base du transistor.

On va maintenant décrire en se référant à la figure 3 une variante de l'invention dans laquelle les moyens de commande utilisent un générateur de tension. Les éléments analogues des figures 1 et 2 portent les mêmes références.

Sur la figure 3, un dispositif de contrôle 1' comporte des moyens de commande 6', ce dispositif n'étant pas couvert par la portée des revendications. Ces moyens de commande 6', comportent, en série et en partant d'un point de connexion à la portion 2b, un générateur ajustable de tension 7, une résistance 8, et deux diodes 9, la cathode la dernière diode étant connectée à la base du transistor 3. L'utilisation d'un générateur de tension et d'une résistance permet de produire un courant dépendant de la valeur de la résistance et de la valeur de la tension aux bornes du générateur.

A titre indicatif, on peut utiliser un générateur ajustable de tension du type régulateur linéaire, par exemple un régulateur linéaire série ou parallèle.

On peut également utiliser un régulateur à découpage, par exemple un régulateur DC/DC La tension générée par le générateur de tension 7 peut produire un courant qui commande la base du transistor 3. Lors d'une variation de température, les diodes 9 compensent ces variations de température pour maintenir une même limitation du courant qui circule dans la ligne d'alimentation.

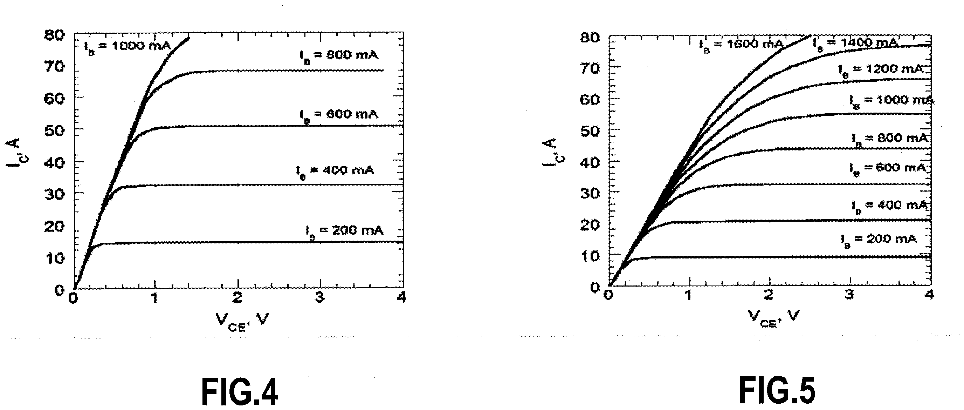

Sur la figure 4, on a représenté une caractéristique courant-tension du transistor 3, par exemple le transistor 3 du dispositif 1 de la figure 1. Dans l'exemple de la figure 3, le transistor 3 est utilisé à une température de 25°C.

Sur cette figure, on peut lire en abscisse la tension V_{CE} entre le collecteur et l'émetteur du transistor, et en ordonnée le courant I_{C} qui traverse le transistor.

Différentes courbes ont été tracées en fonction du courant I_{B} qui circule vers la base du transistor.

L'utilisation d'un transistor bipolaire comportant du carbure de silicium permet d'obtenir une limitation du courant I_{C}, et ce même pour des valeurs élevées de plusieurs dizaines d'ampères. Il est donc avantageux d'utiliser de tels transistor pour les applications dans lesquelles la ligne d'alimentation électrique est destinée à recevoir un courant continu haute tension.

Comme on peut le voir sur la figure 5, qui correspond à une utilisation du transistor à une température de 150°C, le courant I_{C} correspondant à une valeur de courant I_{B} diminue par rapport à une utilisation à 25°C. A titre indicatif, le courant I_{C} pour un courant I_{B} passe de 50 Ampères à environ 33 ampères.

On peut noter qu'en fonction de l'application, cette variation peut être acceptable, puisque cela indique que l'on limite le courant jusqu'à 50 ampères quelles que soient les conditions de température. Ceci permet de réduire les risques liés aux courts-circuits et à la foudre.

De manière alternative, il est possible de compenser les variations de température en utilisant des diodes, comme indiqué dans l'exemple de la figure 3.

On peut également noter que la baisse du niveau de courant qui accompagne l'augmentation de la température fournit une protection supplémentaire. En effet, lorsqu'un court-circuit apparait, la température augmente, et le dispositif selon l'invention réduit de manière intrinsèque le courant qui circule.

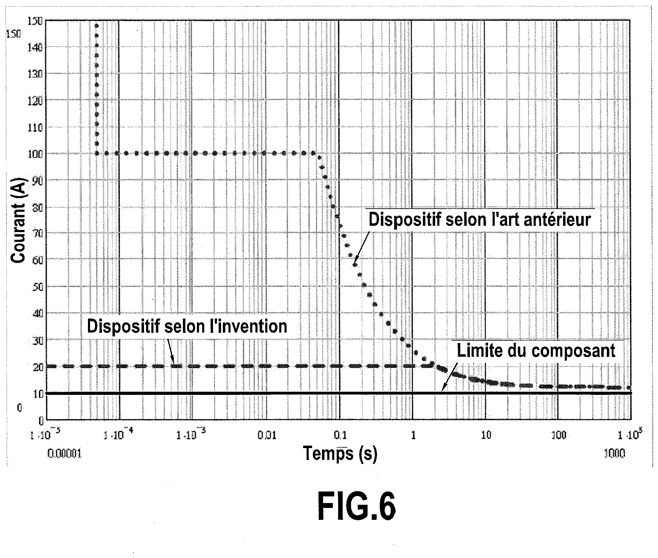

Sur la figure 6, on a représenté l'évolution dans le temps du courant traversant une ligne d'alimentation lors d'une élévation de courant, par exemple due à un court-circuit.

La valeur nominale du courant dans cet exemple est représentée par une ligne continue indiquant une valeur de 10 ampères.

Avec les solutions selon l'art antérieur qui se comportent comme des disjoncteurs électroniques, le courant arrive à des valeurs de l'ordre de 100 ampères avant qu'une action ne soit prise pour faire redescendre la valeur du courant en commandant par exemple un interrupteur.

L'invention permet d'empêcher à tout instant le courant de dépasser 20 ampères, du fait de la structure des transistors bipolaires comportant un matériau semi-conducteur à large bande.

## Revendications

1. Dispositif de contrôle destiné à être placé entre deux portions (2a, 2b) d'une ligne d'alimentation électrique, **caractérisé en ce que** le dispositif comporte un transistor bipolaire (3) comportant un matériau semi-conducteur à large bande et ayant son émetteur (4b) connecté à une portion de la ligne d'alimentation (2b), son collecteur (4a) connecté à une autre portion (2a) de la ligne d'alimentation, le dispositif comportant en outre des moyens de commande (6) connectés à la base (4c) dudit transistor,
**caractérisé en ce que** les moyens de commande (6) sont configurés pour fonctionner en boucle ouverte et sans contreréaction.

2. Dispositif selon la revendication 1, dans lequel lesdits moyens de commande (6) sont configurés pour délivrer un courant à la base dudit transistor, la valeur du courant étant choisie pour limiter une valeur maximale du courant traversant les portions de la ligne d'alimentation.

3. Dispositif selon l'une quelconque des revendications 1 à 2, dans lequel lesdits moyens de commande (6) comportent un interrupteur configuré pour connecter la base dudit transistor à une entrée du dispositif destinée à recevoir un premier courant (I1) de commande du transistor, ou à au moins une autre entrée du dispositif destinée à recevoir un deuxième courant (I2) de commande du transistor.

4. Dispositif selon l'une quelconque des revendications 1 à 2, dans lequel les moyens de commande (6') comportent un générateur ajustable de tension (7) et une résistance (8).

5. Dispositif selon la revendication 4, comportant en outre au moins une diode (9) disposée en série avec la résistance et le générateur ajustable de tension.

6. Dispositif selon l'une quelconque des revendications 1 à 5, dans lequel la ligne d'alimentation électrique est destinée à recevoir un courant continu haute tension.

7. Dispositif selon l'une quelconque des revendications 1 à 6, dans lequel le matériau semi-conducteur à large bande est choisi dans le groupe formé par : le carbure de silicium, le nitrure de gallium, et l'arséniure de gallium.

8. Système comprenant une source d'alimentation (1100), une charge, au moins une ligne d'alimentation (200, 200') reliant ladite source d'alimentation à ladite charge (1200), et au moins un dispositif (100, 100') selon l'une quelconque des revendications 1 à 7 placé entre deux portions de ladite au moins une ligne d'alimentation.

## Patentansprüche

1. Steuerungsvorrichtung, die dazu vorgesehen ist, zwischen zwei Abschnitte (2a, 2b) einer Stromleitung platziert zu werden, **dadurch gekennzeichnet, dass** die Vorrichtung einen Bipolartransistor (3) beinhaltet, der ein Breitband-Halbleitermaterial beinhaltet und dessen Emitter (4b) mit einem Abschnitt der Stromleitung (2b) verbunden ist und dessen Kollektor (4a) mit einem anderen Abschnitt (2a) der Stromleitung verbunden ist, wobei die Vorrichtung ferner Steuermittel (6) beinhaltet, die mit der Basis (4c) des Transistors verbunden sind,
**dadurch gekennzeichnet, dass** die Steuermittel (6) dazu ausgestaltet sind, mit offener Schleife und ohne Rückführung zu funktionieren.

2. Vorrichtung nach Anspruch 1, wobei die Steuermittel (6) dazu ausgestaltet sind, einen Strom an die Basis des Transistors abzugeben, wobei der Stromwert ausgewählt wird, um einen Höchststromwert zu begrenzen, der durch die Abschnitte der Stromleitung fließt.

3. Vorrichtung nach einem der Ansprüche 1 bis 2, wobei die Steuermittel (6) einen Schalter beinhalten, der dazu ausgestaltet ist, die Basis des Transistors mit einem Eingang der Vorrichtung, der dazu vorgesehen ist, einen ersten Steuerstrom (11) des Transistors aufzunehmen, oder mit mindestens einem anderen Eingang der Vorrichtung, der dazu vorgesehen ist, einen zweiten Steuerstrom (I2) des Transistors aufzunehmen, zu verbinden.

4. Vorrichtung nach einem der Ansprüche 1 bis 2, wobei die Steuermittel (6') einen einstellbaren Spannungsgenerator (7) und einen Widerstand (8) beinhalten.

5. Vorrichtung nach Anspruch 4, die ferner mindestens eine Diode (9) beinhaltet, die in Reihe mit dem Widerstand und dem einstellbaren Spannungsgenerator angeordnet ist.

6. Vorrichtung nach einem der Ansprüche 1 bis 5, wobei die Stromleitung dazu vorgesehen ist, einen Hochspannungsgleichstrom aufzunehmen.

7. Vorrichtung nach einem der Ansprüche 1 bis 6, wobei das Breitband-Halbleitermaterial ausgewählt ist aus der Gruppe bestehend aus: Siliciumcarbid, Galliumnitrid und Galliumarsenid.

8. System, umfassend eine Stromquelle (1100), einen Verbraucher, mindestens eine Stromleitung (200, 200'), welche die Stromquelle mit dem Verbraucher (1200) verbindet, und mindestens eine Vorrichtung (100, 100') nach einem der Ansprüche 1 bis 7, die zwischen mindestens zwei Abschnitten einer Stromleitung platziert ist.

## Claims

1. A control device for connecting between two portions (2a, 2b) of an electrical power supply line, the device being **characterized in that** it comprises a bipolar transistor (3) comprising a wide bandgap semiconductor material and having its emitter (4b) connected to one portion of the power supply line (2b), its collector (4a) connected to another portion (2a) of the power supply line, and the device also comprising control means (6) connected to the base (4c) of said transistor and configured to operate in an open loop and without feedback.

2. A device according to claim 1, wherein said control means (6) are configured to deliver a current to the base of said transistor, the value of that current being selected to limit the current flowing in the power supply line portions to a maximum value.

3. A device according to claim 1 or claim 2, wherein the control means (6) comprise a switch configured to connect the base of said transistor either to an input of the device for receiving a first transistor control current (I1), or else to at least one other input of the device for receiving a second transistor control current (12).

4. A device according to claim 1 or claim 2, wherein the control means (6') comprise an adjustable voltage generator (7) and a resistor (8).

5. A device according to claim 4, further comprising at least one diode (9) connected in series with the resistor and the adjustable voltage generator.

6. A device according to any one of claims 1 to 5, wherein the electrical power supply line is for receiving a high voltage direct current.

7. A device according to any one of claims 1 to 6, wherein the wide bandgap semiconductor material is selected from the group constituted by: silicon carbide; gallium nitride; and gallium arsenide.

8. A system comprising a power supply (1100), a load, and at least one power supply line (200, 200') connecting said power supply to said load (1200), and at least one device (100, 100') according to any one of claims 1 to 7 connected between two portions of said at least one power supply line.
